# EUROPÄISCHE PATENTSCHRIFT

(11) **EP 0 619 333 B1**
(45) Veröffentlichungstag und Bekanntmachung des Hinweises auf die Patenterteilung: **02.06.1999**
(21) Anmeldenummer: 94250083.6
(22) Anmeldetag: 31.03.1994
(51) Int. Cl.: C08G 61/12, H05K 3/06, H05K 3/00, H05K 3/28

(54) **Verfahren zum Beschichten von Metallen**
Process for coating metals
Procédé de revêtement de métaux

(30) Priorität: 03.04.1993 DE 4311807
(43) Veröffentlichungstag der Anmeldung: 12.10.1994
(73) Patentinhaber: ATOTECH Deutschland GmbH, 10553 Berlin (DE)
(72) Erfinder: Tenbrink, Detlef, D-13437 Berlin (DE); Guggemos, Michael, D-14109 Berlin (DE)
(74) Vertreter: Effert, Udo

(56) Entgegenhaltungen:
- EP-A- 0 178 864
- EP-A- 0 364 132
- EP-A- 0 513 831
- WO-A-90/10095
- DE-A- 3 141 680
- DE-A- 3 842 398
- FR-A- 2 679 240
- US-A- 5 089 304
- METALLOBERFLACHE Bd. 46, Nr. 4 , April 1992 , MUNCHEN DE Seiten 177 - 182 F.BECK 'Neuer Weg zum Korrosionsschutz:Elektrochemisches Abscheiden von leitenden Polymeren'
- CHEMICAL ABSTRACTS, vol. 113, no. 16, 15. Oktober 1990, Columbus, Ohio, US; abstract no. 132976j, D.MINEHAN ET ALL. 'Electrooxidation of imidazole to form soluble electroactive polymer' Seite 10 ; & POLYM. PRPR. Bd. 31, Nr. 1 , 1990 Seiten 390 - 391
- CHEMICAL ABSTRACTS, vol. 116, no. 8, 24. Februar 1992, Columbus, Ohio, US; abstract no. 70331w, S.TRIPATHY 'Electrooxidation of imidazole to form soluble electroactive polymer' Seite 737 ; & GOV. REP. ANNOUNCE INDEX Bd. 91, Nr. 8 , 1991 , U.S. 'abstr. 118.373'
- CHEMICAL ABSTRACTS, vol. 116, no. 10, 9. März 1992, Columbus, Ohio, US; abstract no. 84304b, W.HSING LIN ET ALL. 'Electrochemical polymerization of imidazole and some of its derivatives' Seite 8 ; & POLYM.PREPR. Bd. 32, Nr. 1 , 1991 Seiten 627 - 628

## Beschreibung

Die Erfindung betrifft ein Verfahren zum Beschichten von Metallen, vorzugsweise von Kupfer oder von Kupferlegierungen, insbesondere zur Herstellung von Leiterplatten.

Die Beschichtung von Metallen wird in verschiedenen Anwendungsgebieten eingesetzt. Beispielsweise werden Metalle zum Zwecke des Korrosionsschutzes mit organischen Filmbildnern behandelt. Ein weiteres sehr wichtiges Einsatzgebiet ist die Leiterplattentechnik, bei der organische Schutzschichten sowohl als Ätz- als auch als Anlaufschutz vor dem Löten verwendet werden.

In der Regel werden heute bei der Herstellung von Leiterplatten zur Erzeugung der Leiterbahnstrukturen auf der Leiterplattenoberfläche zwei Verfahren eingesetzt, die als Panel-plating- und als Pattern-plating-Verfahren bezeichnet werden. Außerdem gibt es Mischformen dieser beiden Techniken.

Beim Panel-plating-Verfahren wird die gebohrte Leiterplatte einem stromlosen Metallisierungsprozeß unterworfen, bei dem die Bohrlochwände und die Leiterplattenoberfläche mit einer Kupferschicht überzogen werden. Anschließend erfolgt eine elektrolytische Verkupferung der gesamten Leiterplatte unter Einschluß der Bohrungen mit dem Ziel, die erforderliche Gesamtschichtdicke der Kupferschicht in den Bohrungen zu erreichen. Danach wird mit Hilfe eines organischen Ätzresists die Leiterbahnstruktur auf der Leiterplattenoberfläche abgebildet, so daß die nicht zu den Leiterbahnen gehörenden Kupferbereiche in einem Ätzprozeß entfernt werden können. Hierzu wird meist ein photosensitiver Festresist, der sogenannte Tentingfilm, eingesetzt, der die Bohrungen während des Ätzschrittes durch ein Überspannen der Bohrungseintrittsöffnung schützt. Nach dem Ätzprozeß wird der organische Ätzresist wieder entfernt.

Mit dieser Verfahrensweise können relativ grobe Strukturen der Lötaugen erzeugt werden, da der Tentingresist als sichere Auflagefläche auf der Leiterplattenoberseite einen Mindestüberstand neben der Bohrung erfordert. Auf der Leiterplattenoberseite wird der um die Bohrung herum angeordnete Kupferring relativ groß; Leiterzüge können daher nicht in genügender Anzahl zwischen zwei Bohrlochhöfen hindurchgeführt werden, so daß die gewünschte Leiterbahndichte auf der Leiterplattenaußenseite nicht erreicht werden kann.

Beim Pattern-plating-Verfahren wird im Unterschied zum Panel-plating-Verfahren nach der stromlosen Verkupferung, die ebenfalls zur Bohrlochmetallisierung durchgeführt wird, nur eine dünne elektrolytische Kupferschicht ganzflächig aufgebracht. Anschließend erfolgt die Leiterzugstrukturierung mittels eines organischen Resists, der die nicht zu den Leiterzugstrukturen gehörenden Oberflächenbereiche bedeckt. Danach werden durch elektrolytische Metallabscheidung die Kupferschicht in erforderlicher Dicke und eine zusätzliche metallische Ätzresistschicht auf der Kupferschicht in den Bohrungen und Galvanoresistkanälen erzeugt. Nach dem Entfernen des organischen Resists von der Leiterplattenoberfläche werden die nicht von dem metallischen Ätzresist bedeckten Oberflächenbereiche mit einer Ätzlösung von der dort befindlichen Kupferschicht befreit, so daß die Leiterbahnstruktur entsteht. Nach Abschluß des Ätzprozesses wird der metallische Ätzresist wieder entfernt, um die Kupferoberfläche freizulegen. Die Haftung der anschließend aufzubringenden Lötstoppmaske ist auf dem Kupfer erheblich besser als auf dem schmelzbaren Metallresist.

Die Entfernung des metallischen Ätzresists, meist Zinn oder eine Zinn/Blei-Legierung, kann nur mit abwassertechnisch beziehungsweise arbeitssicherheitstechnisch bedenklichen Ätzlösungen bewerkstelligt werden und erhebliche Kosten verursachen (Fluorid-, Salpetersäure-haltig). Außerdem entstehen durch Lokalelementbildung zwischen metallischem Ätzresist und Kupfer unerwünschte Leiterzugquerschnitte.

Bekannt ist nach US-PS 4 861 438 auch die elektrochemische Abscheidung Isocyanatgruppen-enthaltender polymerer Ätzresistschichten auf Metalloberflächen. Dieser vorwiegend bei der Herstellung von Leiterplatten eingesetzte Elektrotauchlack wird mit organischen Lösungsmitteln von den Metalloberflächen entfernt, wobei der Einsatz dieser Lösungsmittel aus Gründen des Umweltschutzes bedenklich ist und in der Praxis eine Reihe von kostenintensiven Sicherheitsmaßnahmen erfordert.

Beschrieben sind auch Ätzresistschichten, gebildet aus monomeren organischen Verbindungen, die gleichzeitig einen Anlaufschutz erzeugen. Die Verfahren zur Herstellung dieser Schichten werden beispielsweise in den Druckschriften EP-0 178 864 B1, EP-O 364 132 A1, JP-89-164 291 und JP-3-235 395 beschrieben. Bekannt sind auch Imidazol- beziehungsweise Benzimidazolderivat-haltige Bäder.
EP-0 364 132 A1 beschreibt außerdem die Verwendung von Kupfer- und/oder Zinkionen enthaltenden Lösungen, die die Ätzschutzwirkung verbessern sollen. Hierzu werden die Metallionen zusammen mit der Imidazollösung in Kontakt mit der Leiterplatte gebracht.
Die so auf dem Metall gebildeten Filme sind sehr dünn. Ein zuverlässiger Ätzschutz ist nur bei Porenfreiheit gegeben, die wiederum bei dünnen Schichten kaum erreichbar ist. Daher ist die Ausschußrate nach dem Ätzen meist sehr hoch.

Außerdem kann durch die saure Lösung der filmbildenden Verbindung Kupferoxid von den Kupferflächen gelöst werden und als Kupferionen in die Lösung gelangen. Damit steigt die Kupferionenkonzentration in der Lösung an und es kann leicht zu Ausfällungen von Kupferkomplexen der Stickstoffverbindungen kommen.

Aus der Praxis sind weiterhin elektrophoretische Abscheidungsverfahren für die Erzeugung von Ätzresistfilmen auf Leiterplatten bekannt, bei denen der Ätzresistfilm durch Abscheiden von filmbildenden Mizellen aus der Lösung gebildet wird. Der Film bildet sich, wenn eine elektrische Spannung zwischen dem zu beschichtenden Substrat und einer zweiten Elektrode angelegt wird.
Das Verfahren ist recht aufwendig, da zum Erreichen eines ausreichenden Ätzschutzes eine Vielzahl von Parametern exakt aufeinander abgestimmt werden muß. Darüber hinaus wird beim elektrophoretischen Filmbildungsverfahren mit einer vergleichsweise hohen Spannung (80 - 250 Volt) gearbeitet, was einen hohen sicherheitstechnischen Aufwand erfordert.

Der Erfindung liegt daher das Problem zugrunde, ein Verfahren zum Beschichten von Metallen, vorzugsweise von Kupfer oder von Kupferlegierungen zu finden, um diese vor einem Korrosions- beziehungsweise Ätzangriff, insbesondere bei der Herstellung von Leiterplatten, zu schützen.

Gelöst wird das Problem durch ein Verfahren gemäß Patentanspruch 1 dadurch, daß die zu beschichtende Oberfläche mit einer eine monomere Stickstoffverbindung oder Gemische dieser Verbindungen enthaltenden Lösung in Kontakt gebracht und durch elektrochemische Reaktion eine Oberflächenverbindung auf dem Metall gebildet wird. Als monomere Stickstoffverbindungen werden Imidazol, Benzimidazol, Triazol, Benzotriazol, Pyrazol, Oxazol, Isoxazol, Thiazol, Benzothiazol, Indol, Adenin, Purin, Chinolin, Pyrazin, Chinazolin, Guanin, Xanthin, Hypoxanthin, Indazol, Kreatinin, Phenazin und deren Derivate sowie Kupferren und Benzamidin eingesetzt. Weitere Ausgestaltungen der Erfindung sind den Unteransprüchen zu entnehmen.

Dabei wird zumindest während eines Teils der Beschichtungsdauer eine elektrische Spannung zwischen der beispielsweise in einem Bad befindlichen zu beschichtenden Oberfläche und einer zweiten in diese Lösung eintauchenden Elektrode angelegt oder diese stellt sich ein, so daß ein elektrischer Strom zwischen der zu beschichtenden Oberfläche und der zweiten Elektrode fließt. Bei diesem Vorgang kann die zu beschichtende Oberfläche als Anode und die zweite Elektrode als Kathode ausgebildet sein.
Das Verfahren kann allgemein zum Auftragen von gegen Korrosion schützenden organischen Überzügen eingesetzt werden. Bevorzugt wird es zur leiterzugstrukturierung von durchkontaktierten Leiterplatten angewendet.

Das erfindungsgemäße Verfahren umgeht Nachteile der bekannten Prozesse. Das Verfahren zeichnet sich durch eine gute Umwelt- und Arbeitssicherheitsverträglichkeit aus; es ist einfach und ermöglicht wesentlich höhere Prozeßausbeuten.

Neu und wirkungsvoll ist, daß die elektrochemische Abscheidung des organischen Schutzfilmes auf den Metallflächen zu einer ätzresistenteren Schichtbildung als bei stromloser Abscheidung führt. Dies ist leicht erkennbar an der erhöhten Beständigkeit des Ätzresistfilmes beim Ätzprozeß.

So bilden sich während des elektrochemischen Abscheidungsvorganges durch die anodische Auflösung des Metalls an der Kupferoberfläche Kupferionen, die für die verstärkte Filmbildung ursächlich sind. Die Metallionen binden hierbei die monomeren Stickstoffverbindungen über Elektronen-Donator/Akzeptor-Bindungen.

Daraufhin findet eine stärkere "Vernetzung" der monomeren Stickstoffverbindungen unter Bildung einer kompakteren und dichteren Schicht durch die Kupferionen statt. Es entstehen Schichten mit höherer Schichtdicke, so daß auf diese Weise die Ätzresistenz des Filmes erhöht wird. ESCA-Spektren zeigen einen erhöhten Kupfergehalt in der Schicht, verglichen mit solchen, die ohne gleichzeitige anodische Auflösung von Kupfer hergestellt worden sind, also beispielsweise durch kathodische Polarisation der Substratoberfläche oder ohne Polarisation.

In der Druckschrift EP-0 364 132 A1 und der neueren Anmeldung JP-3-235395 wird darauf hingewiesen, daß sich die Anwesenheit von Kupfer- beziehungsweise Zinkionen in der Behandlungslösung vorteilhaft auf die Filmbildung auswirkt. Allerdings werden die Ionen in den Verfahren, die im Stand der Technik genannt sind, als Metallsalze zu den Behandlungslösungen zugegeben beziehungsweise in einem nachfolgenden Behandlungsschritt mit der Leiterplatte in Kontakt gebracht. In diesen Verfahren wird auf den Kupferflächen zwar eine bessere Ätzschutzwirkung als ohne Anwendung der Kupfer- oder Zinkionen in Lösung, jedoch nicht die geforderte Ätzresistenz des Filmes erreicht.

Im Gegensatz dazu werden die für die effiziente Filmbildung erforderlichen Kupferionen nach dem erfindungsgemäßen Verfahren durch anodisches Auflösen des Kupfers von den Kupferflächen nur an diesen Stellen gebildet. Die Kupferionen entstehen durch anodische Auflösung auf den Kupferflächen vorzugsweise durch direkten Kontakt der Kupferoberfläche mit der Beschichtungslösung. Nach erfolgter Filmbildung wird die weitere Beschichtung behindert, außer in Bereichen, in denen sich Poren befinden. Dort kann dieser Vorgang fortschreiten, so daß nach der fast vollständigen Bedeckung der Oberfläche mit dem Film die Filmabscheidung in den Poren verstärkt wird, da durch die Auflösung des Kupfers noch Kupferionen entstehen, die an die Filmaußenseite gelangen und dort durch Reaktion mit der filmbildenden Komponente den unlöslichen Niederschlag bilden. Auf diese Weise werden die Poren dicht verschlossen, so daß nach dem erfindungsgemäßen Verfahren die Anzahl der Poren im Film deutlich reduziert ist.

Ein weiterer Vorteil des erfindungsgemäßen Verfahrens besteht darin, daß die während der Kontaktzeit der Leiterplatte mit der Behandlungslösung durch Auflösung von Kupferoxiden von den Kupferflächen in die Lösung gelangenden Kupferionen an der zweiten Elektrode wieder abgeschieden werden. Daher stellt sich ein stationärer Zustand der Kupferionenkonzentration in der Lösung auf recht niedrigem Niveau ein. Daraus resultiert ein wesentlich stabileres Verfahren mit einer deutlich reproduzierbareren Filmbildung, da die Kupferionenkonzentration in der Lösung nur sehr wenig schwanken kann. Im Gegensatz hierzu führt die Auflösung der Kupferoxidschichten in der sauren Behandlungslösung bei den bekannten Verfahren zu einem kontinuierlichen Anstieg des Kupferionengehaltes in der Behandlungslösung, so daß diese häufig regeneriert oder sogar neu angesetzt werden muß, da ein zu hoher Kupferionengehalt zu einer Ausfällung der filmbildenden Komponente im Bad führt. Bei der Erfindung entfallen entsprechend aufwendige und häufige Badüberwachungs- und Instandhaltungsmaßnahmen.

Vorteilhafterweise ist der durch oberflächliche anodische Auflösung der Kupferflächen verstärkte Ätzresistfilm deutlich dunkler gefärbt als bei Verfahren nach dem Stand der Technik. Dadurch ist eine schnelle visuelle Kontrolle der erzeugten Ätzresistschicht möglich, so daß durch diese vereinfachte Prozeßüberwachung eine höhere Verfahrenssicherheit erreicht wird.

Im Gegensatz zu elektrophoretischen Beschichtungsverfahren zeichnet sich das erfindungsgemäße Verfahren durch eine wesentlich einfachere Prozeßführung aus, da die Filmeigenschaften nicht bereits durch die Eigenschaften der in Lösung vorliegenden Mizellen vorgegeben sein müssen, sondern erst durch die Reaktion der filmbildenden Verbindungen mit den an der Metalloberfläche entstehenden Kupferionen gebildet werden. Außerdem wird im allgemeinen mit deutlich geringeren Spannungen gearbeitet, woraus wesentlich geringere Sicherheitsanforderungen und damit geringere Kosten für die Behandlungsanlage resultieren.

So wird erfindungsgemäß durch Anlegen eines Potentials an die Kupferflächen der Leiterplatte beziehungsweise durch einen Stromfluß zwischen der Leiterplattenoberfläche und einer zweiten Elektrode eine anodische Auflösung der Kupferoberfläche unter Bildung von Cu(I)- und/oder Cu(II)-Ionen bewirkt, die wiederum die Funktion der Schichtverstärkung an diesen Stellen wahrnehmen. Durch diese "Polymerisation" der monomeren Stickstoffverbindungen mit den Kupferionen, durch die der Ätzschutzfilm gegen chemische Einflüsse "gehärtet" wird, und durch Erzeugen einer porenfreien Schicht, wird ein guter Ätzschutz auf den Kupferflächen erreicht.

Wird an die Leiterplatte anodisch ein Potential zwischen 0,001 Volt und 15 Volt, vorzugsweise zwischen 0,5 Volt und 1,5 Volt angelegt, beziehungsweise fließt ein Strom mit einer Stromstärke zwischen 0,001 A/dm² und 10 A/dm², vorzugsweise zwischen 0,1 A/dm² und 1 A/dm², so wird Kupfer an den vom Photoresist oder Siebdrucklack freigelegten Kupferoberflächen kontrolliert oxidiert. Somit entstehen die Cu(I)-oder Cu(II)-Ionen, die für die Ausbildung einer kompakteren beziehungsweise dickeren Schicht verantwortlich sind, an der Stelle, wo sie benötigt werden.

Eine weitere Ausgestaltung des Verfahrens besteht darin, daß nicht notwendigerweise eine vorgegebene Spannung zwischen der zu beschichtenden Oberfläche und einer zweiten ebenfalls in die Behandlungslösung eintauchenden Elektrode mit Hilfe einer externen Spannungsquelle vorgegeben werden muß, um den der Erfindung entsprechenden Effekt der anodischen Auflösung des Kupfers und die damit verbundene erhöhte Ätzresistenz der Beschichtung gegenüber alkalischen Ätzmitteln zu erreichen. Hierzu kann beispielsweise die sich in der Lösung einstellende Potentialdifferenz zwischen der zu beschichtenden Metalloberfläche und einer zweiten metallischen Oberfläche ausgenutzt werden, indem eine elektrische Verbindung zwischen der zu beschichtenden Oberfläche und der zweiten Metalloberfläche hergestellt wird und sich die zu beschichtende Oberfläche unedler verhält als die zweite Metalloberfläche.

So ist die Häufigkeit der Ätzdefekte, hervorgerufen durch Poren im Ätzresist, nach dem Ätzen von Leiterplatten signifikant geringer, wenn beispielsweise eine Elektrode aus Edelstahl verwendet wird. Es wurden auch Leiterplatten mit in die Behandlungslösung eintauchenden Goldelektroden elektrisch verbunden, um die verstärkte Ätzresistenz zu erreichen. Auch die sich einstellende Potentialdifferenz zwischen der Kupferoberfläche der Leiterplatten und dem metallischen Gestell, in dem die Leiterplatten gehalten werden, wenn ein elektrischer Kontakt zwischen den beiden Metalloberflächen hergestellt wird, bewirkt den erfindungsgemäßen Effekt.

Zusammen mit der für Ätzanwendungen notwendigen Wärmebehandlung führt das erfindungsgemäße Verfahren daher zu besonders dichten und korrosionsfesten Beschichtungen, die nicht mehr den Nachteil von Poren und anderen Defekten aufweisen.

Für die Anwendung in der Leiterplattentechnik kann das Verfahren sowohl im Panel-Plating-, im Pattern-Plating-Verfahren als auch in einer Mischvariante dieser Verfahren angewendet werden. Es sind also beispielsweise die folgenden allgemeinen Verfahrensabläufe möglich:

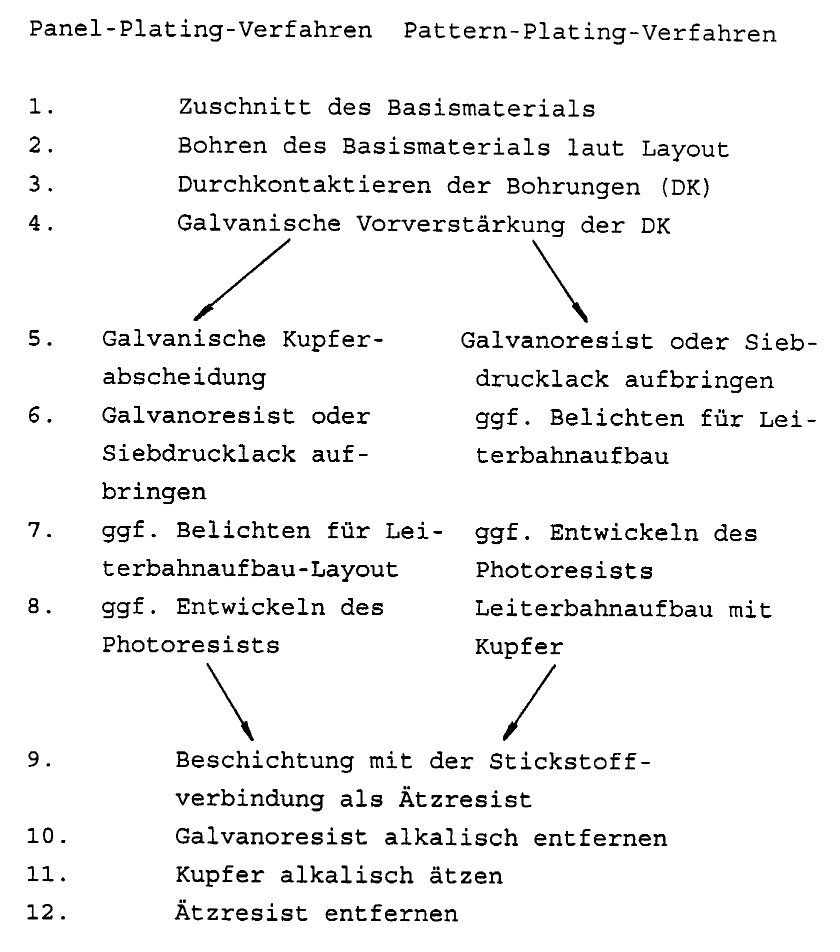

Die für die Filmbildung erforderlichen Prozeßschritte werden im nachfolgenden Schema angegeben:
(a) Erzeugen eines Negativbildes auf einer Leiterplatte mit einem alkalisch entfernbaren Resist auf mindestens einer Seite der Leiterplatte,
(b) Eintauchen der Leiterplatte in eine die monomere Stickstoffverbindung oder Gemische dieser Verbindungen enthaltende vorzugsweise saure Lösung, wobei zumindest während eines Teils der Behandlungszeit eine elektrische Spannung zwischen den Metalloberflächen der Leiterplatte und einer zweiten in die Behandlungslösung eingetauchten Elektrode, die als Kathode gegenüber der Leiterplatte polarisiert wird, angelegt wird oder sich aufgrund der Art der Metalle von selbst einstellt,
(c) gegebenenfalls Abspülen der überschüssigen Lösung,
(d) gegebenenfalls Trocknen beziehungsweise Tempern der Leiterplatte,
(e) selektives Entfernen des alkalisch entfernbaren Resists von der Leiterplattenoberfläche durch Eintauchen in eine alkalische Lösung, so daß die darunter liegenden Kupferflächen freigelegt werden,
(f) Entfernen der freigelegten Kupferflächen durch einen alkalischen Ätzprozeß,
(g) gegebenenfalls Entfernen der stickstoffhaltigen Schicht durch Behandlung in einer sauren wäßrigen Lösung.

Diesem Verfahrensablauf können weitere Prozeßschritte hinzugefügt werden, beispielsweise um die Haftung des erzeugten Schutzfilmes auf der Kupferoberfläche zu erhöhen. Hierzu dienen Lösungen, die Kupfer oberflächlich anrauhen, wie beispielsweise Oxidationsmittel, die in wäßriger Lösung gelöst werden. Bevorzugt werden Stoffe, wie Natrium- oder Ammoniumperoxodisulfat, Natriumcarbonat und Wasserstoffperoxid, das in einer schwefelsauren Lösung gelöst wird. Außerdem werden Reinigungslösungen eingesetzt, die Verunreinigungen von den Kupferoberflächen beseitigen.

Die Beschichtungslösung wird vorzugsweise als wäßrige Lösung eingesetzt. Selbstverständlich können auch organische Lösungsmittel verwendet werden, beispielsweise, um die Löslichkeit der monomeren Stickstoffverbindungen zu erhöhen. Allerdings ist Wasser wegen seiner Umweltfreundlichkeit und wegen der geringen Beschaffungskosten anderen Lösungsmitteln vorzuziehen. Die Beschichtungslösung enthält neben der filmbildenden Komponente zusätzlich eine oder mehrere Säuren und gegebenenfalls lösungsvermittelnde Alkohole.

Als filmbildende Komponente wird eine monomere Stickstoffverbindung eingesetzt. Es können auch gleichzeitig mehrere dieser Verbindungen verwendet werden. Als monomere Stickstoffverbindungen kommen insbesondere cyclische Verbindungen in Betracht. Bevorzugt sind Derivate der monomeren Stickstoffverbindungen, die mit einer nichtverzweigten, linearen oder verzweigten Alkylkette mit mindestens drei Kohlenstoffatomen und/oder mit einem aromatischen Rest, vorzugsweise einem substituierten oder unsubstituierten Phenylrest, direkt oder über Alkylketten, und/oder mit Aminogruppen direkt oder über Alkylketten substituiert sind. Es können Verbindungen wie beispielsweise Imidazol, Benzimidazol, Triazole, Benzotriazole, Pyrazol, Oxazol, Isoxazol, Thiazol, Benzothiazol, Indol, Adenin, Purin, Chinolin, Pyrazin, Chinazolin, Guanin, Xanthin, Hypoxanthin, Indazol, Kreatinin, Phenazin, deren Derivate und/oder deren Mischungen untereinander oder mit anderen Stoffen verwendet werden. Besonders bevorzugt sind Imidazol- und Benzimidazolderivate. Unter diesen sind hervorzuheben die in 2-Stellung substituierten Alkyl- und Phenylderivate. Außerdem kann unter anderem Kupferron oder Benzamidin eingesetzt werden. Grundsätzlich können die in den Druckschriften EP-0 428 383 A1, EP-0 428 260 A2, DE-OS 40 39 271 und US-PS 4 731 128 genannten Stoffe verwendet werden.

Bei der Wahl der monomeren Stickstoffverbindung ist darauf zu achten, daß die Entfernbarkeit des daraus entstehenden Filmes auch nach dem Temperschritt ausreichend hoch ist. Falls es nach dem Ätzprozeß nicht gelingt, den Ätzschutzfilm vollständig und ohne Rückstände von der Kupferoberfläche zu entfernen, ist mit mangelhaften Ergebnissen beim nachfolgenden Lötprozeß zu rechnen.

Für die Anwendung in der Leiterplattentechnik als Ätzresist muß die monomere Stickstoffverbindung in saurer wäßriger Lösung in ausreichender Konzentration löslich sein, während die Verbindung in alkalischer wäßriger Lösung unlöslich sein sollte.

Die eingesetzte monomere Stickstoffverbindung kann auch als Säuresalz auf die Oberfläche gebracht werden. In der Tat wird vorzugsweise eine saure Lösung der Stickstoffverbindung appliziert, in der die protonierten Spezies der Stickstoffverbindung zusammen mit den Anionen der eingesetzten Säure vorliegen.

Daher ist es naheliegend und äquivalent, daß statt der freien Stickstoffbase das korrespondierende Salz einer Säure zum Einsatz kommt. Als Säureanionen dieser Salze können grundsätzlich beliebige anorganische und organische Verbindungen verwendet werden.

Die Konzentration der eingesetzten monomeren Stickstoffverbindungen kann in weiten Bereichen, beispielsweise zwischen 0,001 g/l und 400 g/l, variiert werden. Für den jeweiligen Anwendungsfall kommen jedoch in der Regel nur sehr viel engere Konzentrationsbereiche in Betracht, die sich zum einen aus der Löslichkeit der Verbindung beziehungsweise aus der Wirtschaftlichkeit des Verfahrens und zum anderen aus der erforderlichen Verweildauer des Substrates im Behandlungsbad sowie der gewünschten Schutzwirkung des erzeugten Filmes aus der monomeren Stickstoffverbindung ergeben. Vorteilhaft ist daher in der praktischen Anwendung ein Konzentrationsbereich zwischen 1 g/l und 50 g/l.

Als Säuren, die der Lösung zugesetzt werden, um die monomere Stickstoffverbindung in ausreichender Menge in dem Lösungsmittel zu lösen, können sowohl anorganische als auch organische Säuren, wie beispielsweise Phosphorsäure, Schwefelsäure, Salzsäure, phosphorige Säure, Ameisensäure, Essigsäure, Glykolsäure, Oxalsäure, Bernsteinsäure, Maleinsäure, Weinsäure, Adipinsäure, Milchsäure und andere Säuren verwendet werden, die geeignet sind, einen pH-Wert in der Lösung einzustellen, der eine ausreichend hohe Löslichkeit der monomeren Stickstoffverbindung ermöglicht.

Der pH-Wert der Lösung wird durch die Konzentration und Art der Säure, die zugesetzt wird, bestimmt. Er soll kleiner als 7 sein und liegt vorzugsweise zwischen 2 und 5. Beispielsweise liegt der pH-Wert zwischen 2,6 und 3,0, wenn eine Lösung verwendet wird, die Ameisensäure in einer Konzentration von 30 g/l bis 40 g/l und als monomere Stickstoffverbindung 2-n-Heptylbenzimidazol enthält.

Weiterhin kann die Beschichtungslösung basische Substanzen wie beispielsweise Amine, beispielsweise aliphatische Amine, enthalten, die als Puffer (pH-Stabilisierung) wirken. Bevorzugt sind primäre und sekundäre Amine wie Ethylendiamin, Monoalkylamine, Dialkylamine, wie beispielsweise Dimethylamin oder Diethylamin, oder Ethanolamine, wie Monoethanolamin, Diethanolamin oder Triethanolamin.

Die Beschichtungslösungen enthalten vorzugsweise keine zugesetzten Kupfersalze oder andere Schwermetallsalze, wie sie in den nach dem Stand der Technik bekannten Verfahren eingesetzt werden, da die erforderliche Ätzresistenz der Beschichtung bereits durch die erfindungsgemäße Verfahrensweise ermöglicht wird.

Die Temperatur der Behandlungslösung kann zwischen dem Gefrierpunkt und dem Siedepunkt der Lösung liegen. Der praktisch anwendbare Temperaturbereich ist jedoch durch verschiedene Faktoren begrenzt. Eine zu geringe Temperatur, beispielsweise unter 30 °C, hätte eine zu lange Behandlungszeit zur Folge. Eine obere Temperaturgrenze ist durch die Beständigkeit des Galvanoresists auf der Leiterplatte vorgegeben. Dadurch kann die obere Temperaturgrenze der Behandlungslösung für die praktische Anwendung auf etwa 50 °C festgelegt werden. Es sind jedoch Verfahrensvarianten und Anwendungsgebiete denkbar, die höhere oder tiefere Temperaturen erfordern.

Die Behandlungszeit kann ebenfalls in weiten Grenzen variiert werden, wobei keine Zeiten unter 0,1 min und über 60 min gewählt werden sollten. Praktische Bedürfnisse schränken die Behandlungszeiten auf einen engeren Bereich, beispielsweise zwischen 2 min und 10 min ein. Dabei hängt die Behandlungszeit von der Behandlungstemperatur ab.

Nach dem erfindungsgemäßen Verfahren wird das zu beschichtende Substrat in elektrischen Kontakt mit einer externen Stromquelle oder mit einer zweiten Elektrode gebracht, die ebenfalls in die Behandlungslösung eintaucht und sich edler verhält als die zu beschichtende Oberfläche.

Die Spannung zwischen der zweiten Elektrode und dem zu beschichtenden Substrat, sei es daß eine externe Spannungsquelle verwendet wird oder nicht, kann in weiten Grenzen zwischen 0,001 Volt und 15 Volt beziehungsweise Stromstärken zwischen 0,001 A/dm² und 10 A/dm² variiert werden, sollte vorzugsweise jedoch zwischen 0,5 Volt und 1,5 Volt beziehungsweise zwischen 0,1 A/dm² und 1 A/dm² liegen.

In einer besonderen Ausführungsform wird keine externe Stromquelle verwendet, um die Filmbildung aus den monomeren Stickstoffverbindungen zu unterstützen. In diesem Fall wird das Substrat mit einer zweiten Elektrode, die ebenfalls in die Behandlungslösung eintaucht, in direkten elektrischen Kontakt gebracht, wobei die zweite Elektrode sich edler verhält als das zu beschichtende Substrat. Dabei werden Elektroden aus Edelstahl oder Gold verwendet.

Die Beschichtungslösung kann auf unterschiedliche Weise auf die Leiterplatte aufgebracht werden. Üblicherweise wird die Leiterplatte in die Beschichtungslösung eingetaucht. Es ist auch möglich, die Beschichtungslösung auf die Oberfläche zu sprühen oder die Leiterplatte in Durchlaufanlagen zu behandeln, wobei die Beschichtungslösung durch Düsen auf die Oberfläche in einem Flüssigkeitsschwall aufgebracht wird.

Nach der Behandlung in der die monomere Stickstoffverbindung enthaltenden Lösung wird die überschüssige Beschichtungslösung vorzugsweise in einem Spülbad von der Leiterplatte abgespült.

Der entstandene Film wird getrocknet und vorzugsweise einer Temperungsbehandlung unterworfen. Um eine weitere Verdichtung der Schicht zu erhalten, kann der erzeugte Film durch Sauerstoffeinwirkung oder durch Bestrahlung mit Infrarot- oder kurzwelligem Licht, wie beispielsweise UV-Licht, gehärtet werden.

Die Trockentemperaturen und Temper-Behandlungszeiten können abhängig von den praktischen Erfordernissen in weiten Bereichen schwanken. Beispielsweise kann die Trockentemperatur zwischen 60 °C und 260 °C, vorzugsweise zwischen 120 °C und 150 °C und die Temper-Behandlungszeit zwischen 0,1 min und 60 min, vorzugsweise zwischen 5 min und 15 min. gewählt werden. Nach dem Ätzprozeß, der in alkalischem Milieu durchgeführt werden muß, um die Schicht nicht zu beschädigen, wird der Ätzresist wieder von der Kupferoberfläche entfernt. Hierzu werden im allgemeinen saure, wäßrige Lösungen eingesetzt, die den Film lösen.

Die durch das erfindungsgemäße Verfahren hergestellten Schichten eignen sich als Korrosions- und Anlaufschutz von Metalloberflächen aus Kupfer und Kupferlegierungen, Zink und Zinklegierungen sowie Eisen. Hierzu gehören beispielsweise Messing, Bronze und Kupfer/Eisen-, Kupfer/Beryllium-, und Kupfer/Mangan--Legierungen.

Die folgenden Beispiele dienen der Erläuterung der Erfindung.

### Beispiel 1

### Panel-Plating und Siebdruckfarbe

Eine kupferkaschierte Isolierstoffplatte wurde an vorbestimmten Stellen gebohrt und mit bekannten Verfahren durchkontaktiert. Die durchkontaktierte Platte wurde nach der galvanischen Verkupferung mit einem alkalisch strippbaren Siebdrucklack bedruckt und getrocknet, so daß die späteren Leiterbahnen und durchkontaktierten Bohrlöcher freigelegt waren.

Die mit dem Resist präparierte Platte wurde in eine Beschichtungslösung eingetaucht, die auf dem freien Kupfer einen organischen, ätzresistenten Film erzeugt. Diese Beschichtungslösung enthielt
10 g/l 2-n-Heptylbenzimidazol,
32 g/l Ameisensäure
in Wasser.

Während der Behandlungszeit von 5 Minuten in der auf 40 °C erwärmten Beschichtungslösung wurde die Platte mit einem anodischen Konstantstrom von 0,2 A/dm² beaufschlagt (bezogen auf die freie, zu beschichtende Kupferoberfläche einschließlich der Bohrlochflächen).

Die Kathode wurde aus einer Edelstahlplatte gebildet, die das Format der größten zu beschichtenden Leiterplatten hat, die in das Beschichtungsbad eintauchte und mit dem Konstantstrom-Netzgerät verbunden war.

Nach der Beschichtung wurde die Platte mit Wasser gespült und in einem Umluft-Trockenschrank bei 140 °C 10 Minuten lang getrocknet.

Sobald die Platte an der Luft wieder auf Raumtemperatur abgekühlt war, konnte die Siebdruckfarbe in einer Stripplösung aus 50 g/l Ätznatron entfernt werden. Um diesen Vorgang zu beschleunigen, wurde die Natronlauge bis auf 45 °C erwärmt.

Die so wieder freigelegten Kupferflächen ließen sich anschließend in handelsüblichen, ammoniakalischen Kupferätzlösungen entfernen. Die organische Beschichtung mit 2-n-Heptylbenzimidazol widerstand dem Angriff der alkalischen Lösungen.

Bevor die so hergestellte Leiterplatte weiterverarbeitet wurde, mußte der organische Ätzresist mit einer Säure entfernt werden. Dazu war eine 3,5 %ige Salzsäurelösung geeignet. Es folgte ein elektrischer Test der Leiterplatte auf Unterbrechungen und Kurzschlüsse. Bevor die getesteten Platten heißverzinnt wurden beziehungsweise eine Lötstopmaske erhielten, erfolgte noch eine saure Reinigung und eine Mikroaufrauhung der Kupferflächen in bekannten geeigneten Bädern.

### Beispiel 2

### Pattern-Plating und Trockenfilmresist

Eine Leiterplatte mit durchkontaktierten Bohrungen wurde mit einem wäßrig-alkalisch verarbeitbaren Trockenfilmresist laminiert, mit dem passenden Layout-Film belichtet und die nicht belichteten Leiterbahnen mit dem soda-alkalischen Entwickler freigelegt.

Die freientwickelten Kupferpartien einschließlich der Bohrlochwandungen wurden nach vorangegangener Reinigung und Anätzung nach bekannten Verfahren galvanisch mit Kupfer auf die gewünschte Schichtdicke plattiert.

Anschließend erfolgte eine Beschichtung der Kupferoberflächen mit einer wäßrigen Lösung bestehend aus
10 g/l 2-Phenyl-benzimidazol
35 g/l Eisessig
in Wasser.

Während der Behandlungszeit von 5 Minuten bei 40 °C wurde die Leiterplatte als Anode an eine Spannungsquelle von 1,5 Volt angeschlossen und der Stromfluß auf 0,1 A/dm² freier Kupferoberfläche begrenzt. Als Kathode tauchte ein platiniertes Titan-Streckmetall mit etwa gleicher Oberfläche wie die zu beschichtenden Leiterplatten in die Lösung ein.

Die weiteren Bearbeitungsschritte wie Spülen, Trocknen, Strippen des Trockenfilmresists, Kupferätzen und Strippen des organischen Ätzresists erfolgte analog zu Beispiel 1.

Als Ergebnis erhält man die in den Abbildungen la und 1b dargestellten Leiterzugstrukturen, die im Gegensatz zu den im nachfolgenden Vergleichsbeispiel erhaltenen Kupferoberflächen eine perfekte Oberflächenstruktur ohne Unterbrechungen, Kurzschlüsse oder Ätzkrater aufweisen.

### Vergleichsbeispiel

### Pattern-Plating und Trockenfilmresist, ohne Elektrolyse

Eine Leiterplatte mit durchkontaktierten Bohrungen wurde mit einem wäßrig-alkalisch verarbeitbaren Trokkenfilmresist vom Typ Laminar HG (Hersteller Morton Thiokol-USA) laminiert, mit einem passenden Layout-Film UV-belichtet und die nicht belichteten Leiterbahnen und Lötaugen mit dem soda-alkalischen Entwickler freigelegt.

Die freientwickelten Kupferpartien einschließlich der Bohrlochwandungen wurden nach vorangegangener Reinigung und Anätzung nach bekannten Verfahren galvanisch mit Kupfer auf die gewünschte Schichtdicke plattiert.

Anschließend erfolgte nun die Beschichtung der Kupferoberflächen mit einer wäßrigen Lösung bestehend aus
10 g/l 2-Heptylbenzimidazol
33 g/l Ameisensäure
1,0 g/l Kupfer(II)chlorid (CuCl₂·2 H₂O)
in Wasser.

Während der Behandlungszeit von 5 Minuten bei 40 °C wurde die Leiterplatte mit der Warenbewegung leicht hin- und herbewegt und die Badflüssigkeit mit einer Filterpumpe sechsmal pro Stunde umgewälzt.

Nach der Beschichtung wurde wie im Beispiel 1 weiterbehandelt.

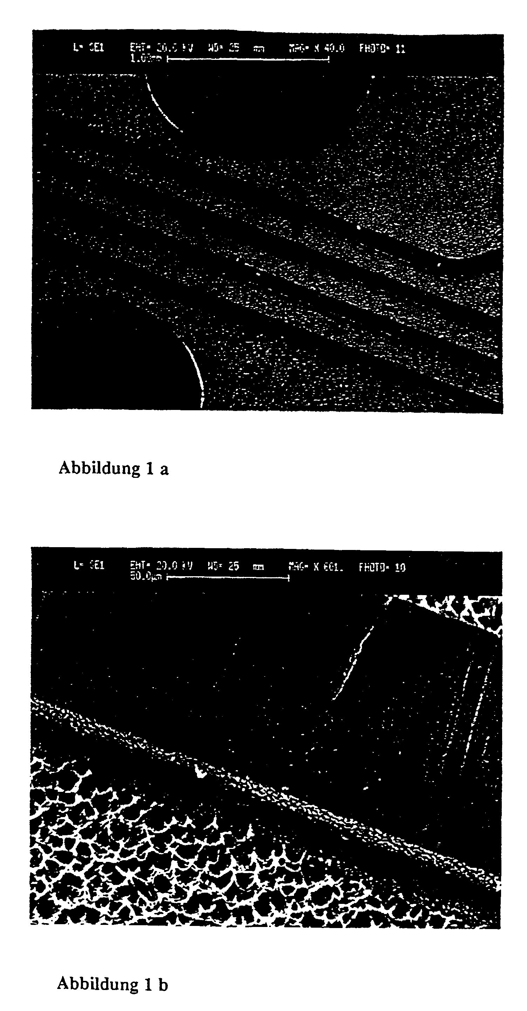

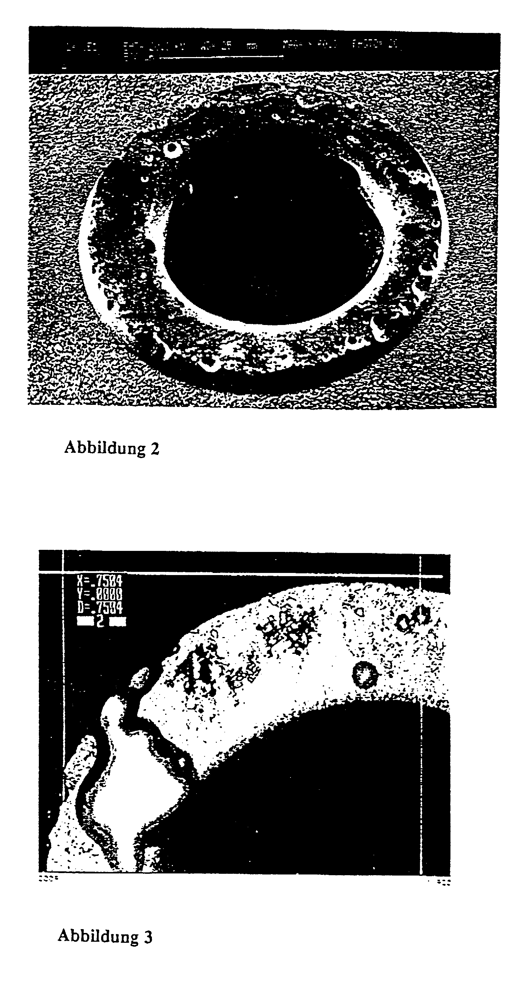

Das Ergebnis zeigen die rasterelektronenmikroskopischen Aufnahmen in Abbildung 2. Im elektrischen Test wurden keine Unterbrechungen oder Kurzschlüsse gefunden. Im Mikroskop erkennt man jedoch überall kleine Ätzmulden in der Kupferoberfläche, obwohl der Prozeß optimiert war.

Abbildung 3 zeigt typische Defekte größeren Ausmaßes durch Einsatz eines handelsüblichen Produktes, wenn in gleicher Weise verfahren wird.

### Beispiel 3

### Panel-Plating - Elektrophoretischer Negativ-Resist

Eine kupferkaschierte Isolierstoffplatte wurde an vorbestimmten Stellen gebohrt und mit bekannten Verfahren durchkontaktiert. Danach erfolgte eine galvanische Verkupferung der gesamten Oberfläche, so daß an den Bohrlochwandungen eine Kupferschichtdicke von 25 µm entstand.

Die Platte wurde in dem elektrophoretisch abscheidenden Bad Oligo ED-UV 343 (Fa. Nippon Petrochemicals Co.) mit einem negativ arbeitenden ED-Photoresist beschichtet. Nach dem Spülen und Trocknen der etwa 10 µm dicken Resistschicht wurde mit einem passenden Layout-Film UV-belichtet und die nicht belichteten Leiterbahnen und SMT-Pads mit dem soda-alkalischen Entwickler freigelegt.

Danach wurde die so präparierte Platte in eine Beschichtungslösung eingetaucht, die auf den freientwickelten Kupferflächen einen organischen, ätzresistenten Film erzeugt. Diese Beschichtungslösung enthielt
5 g/l 2,4-Diisopropylimidazol
32 g/l Eisessig
in Wasser.

Behandlungsbedingungen:
Behandlungszeit: 10 Minuten
Badtemperatur: 35 °C
Elektrolyse: 0,2 A/dm² (Leiterplatte anodisch)

Als Kathode diente das Edelstahlgehäuse eines Ultraschallschwingers, der in das Beschichtungsbad eintauchte und in bestimmten Zeitintervallen für einen intensiven Stoffaustausch an der Oberfläche der Leiterplatte sorgte.

Die weiteren Bearbeitungsschritte erfolgten analog zu Beispiel 1.

Nach der Temperung der Leiterplatte und nachfolgendem alkalischen Ätzprozeß wurden Ergebnisse analog den in Beispiel 2 gezeigten erhalten.

### Beispiel 4

### Korrosionsschutz für Kupfer

Ein Kupferblech wurde zum temporären Schutz vor Korrosion und Fingerabdrücken in einem Beschichtungsbad folgender Zusammensetzung behandelt:
10 g/l 2-Phenylbenzimidazol
2 g/l Ethylamin
60 ml/l Salzsäure, 37 %
in Wasser.

Während der Behandlungszeit von 5 Minuten in der auf 45 °C erwärmten Lösung wurde das Blech mit einer Spannungsquelle von 1,5 Volt verbunden. Das Kupferblech war dabei als Anode gepolt. Als Kathode diente die Behälterwandung aus Stahlblech. Der Stromfluß wurde auf 0,1 A/dm² Kupferoberfläche begrenzt.

Im Anschluß an die Beschichtung erfolgte das Spülen des Kupferbleches mit Wasser und das Trocknen der Schutzschicht im Infrarot-Durchlaufofen. Die IR-Strahlungsenergie und die Behandlungsgeschwindigkeit waren so eingestellt, daß die Kupferoberfläche für die Dauer von 5 Minuten auf 145 °C erhitzt wurde und die Schutzschicht nach Abkühlung nicht mehr klebrig war.

Das derartig behandelte Blech wies selbst nach einem Jahr Lagerzeit in normaler Industrieatmosphäre nicht die sonst üblichen Fingerabdruck- und Klimakorrosionsspuren auf. Der Aufwand zur Reinigung vor der Weiterverarbeitung war im Vergleich zu unbehandelten Kupferblechen minimal.

### Beispiel 5

### Korrosionsschutz für Messing

Möbelbeschläge aus Messing wurden zum Oberflächenschutz in einem Beschichtungsbad behandelt, das einen transparenten organischen Schutzfilm auf den Teilen erzeugt. Das Bad enthielt:
5 g/l 2,4-Dimethylimidazol
5 g/l 2-n-Nonylbenzimidazol
1 g/l Toluol-4-sulfonsäure Monohydrat
35 g/l Ameisensäure
in Wasser.

Zur Verdichtung des Überzuges wurde während der Beschichtungszeit von 5 Minuten bei 35 °C Badtemperatur an die zu beschichtenden Messingteile ein anodischer Konstantstrom von 0,15 A/dm² Oberfläche angelegt.

Nach dem Abspülen mit Wasser wurde der transparente Schutzlack in einem Umluftofen für 10 Minuten bei 140 °C eingebrannt.

Im Gegensatz zu den sonst üblichen Klarlackschichten ist diese Schutzschicht dünn, sehr gleichmäßig, sehr einfach aufzubringen und frei von Lacktropfen und Eintrübungen. Auch kommen keine Lösungsmittel zum Einsatz, die Explosionsschutzmaßnahmen erfordern.

### Beispiel 6

### Korrosionsschutz von verzinkten Eisenteilen

Ein Ständergestell aus verzinktem Eisen sollte eine Korrosionsschutzschicht erhalten, ohne daß die Farbe und der metallische Glanz des Zinks eingebüßt werden.

Darüber hinaus hatte das Ständergestell in einem Temperofen einer Dauertemperatur-Behandlung von 120 °C zu widerstehen.

Die bis dahin angewendete Blauchromatierung des Zinks widerstand zwar für 72-100 Stunden dem Salzsprühtest nach DIN 50 021, verlor jedoch die Korrosionsschutzwirkung durch Rißbildung infolge der Dehydratisierung der Chromatschutzschicht bei der Temperatureinwirkung.

Daher wurde eine chromatfreie, transparente Korrosionsschutzschicht in einer Beschichtungslösung mit folgender Zusammensetzung aufgebracht:
5 g/l 2-n-Heptylbenzimidazol
1 g/l 1H-Benzotriazol
1 g/l Zinkacetat Dihydrat
33 g/l Eisessig
in Wasser.

Während der Beschichtung wurde eine anodische Stromdichte von 0,1 A/dm² angelegt. Nach dem Spülen und Trocknen bei 140 °C für 10 Minuten widerstand das so geschützte Ständergestell selbst nach einem einwöchigen Dauereinsatz bei 120 °C dem Salzsprühtest nach DIN für 104 h.

### Beispiel 7

### Korrosionsschutz für Eisen

Transformatorenbleche aus Weicheisen sollten bis zu ihrer Verarbeitung vor Korrosion geschützt werden, ohne den sonst üblichen temporären Schutz durch säurefreie Fette oder Wachse einzusetzen.

Dazu wurden die ausgestanzten Formteile in einer Trommel mit einer Beschichtungslösung behandelt, die folgende Zusammensetzung aufweist:
10 g/l 2-Ethylphenylbenzimidazol
1 g/l Zinkacetat Dihydrat
33 g/l Ameisensäure
in Wasser.

Während der Behandlungszeit von 10 Minuten bei 35 °C Badtemperatur wurde die Trommel in Rotation versetzt und über den Trommelkontakt ein anodischer Strom von 0,3 A/dm² Blechoberfläche aufgeprägt.

Die Bleche wurden in der Galvanisiertrommel gespült und zum Trocknen bei 140 °C in eine Metalltrommel umgefüllt. Während der Trocknungszeit von 15 Minuten wurde die Metalltrommel gedreht, um ein Verkleben der Blechteile zu verhindern.

Man erhält einen sehr guten Anlauf- und Korrosionsschutz für die Weicheisenteile.

## Patentansprüche

1. Verfahren zum Beschichten von Metallen, bei dem die zu beschichtende Oberfläche mit einer eine monomere Stickstoffverbindung, ausgewählt aus der Gruppe der Verbindungen Imidazol, Benzimidazol, Triazol, Benzotriazol, Pyrazol, Oxazol, Isoxazol, Thiazol, Benzothiazol, Indol, Adenin, Purin, Chinolin, Pyrazin, Chinazolin, Guanin, Xanthin, Hypoxanthin, Indazol, Kreatinin, Phenazin und deren Derivate sowie Kupferron und Benzamidin, oder Gemische dieser Verbindungen enthaltenden Lösung in Kontakt gebracht und durch elektrochemische Reaktion eine Oberflächenverbindung auf dem Metall gebildet wird.

2. Verfahren nach Anspruch 1, dadurch gekennzeichnet, daß die zur Bildung der Oberflächenschicht erforderlichen Metallionen ganz oder teilweise durch anodische Auflösung erzeugt werden.

3. Verfahren nach einem der Ansprüche 1 und 2, dadurch gekennzeichnet, daß zumindest zeitweise eine elektrische Spannung zwischen der zu beschichtenden Oberfläche und einer zweiten, in ein Bad mit der die monomeren Stickstoffverbindungen enthaltenden Lösung eintauchenden Elektrode angelegt wird oder sich einstellt, so daß ein elektrischer Strom zwischen der zu beschichtenden Oberfläche und der zweiten Elektrode fließt.

4. Verfahren nach einem der Ansprüche 1 bis 3, dadurch gekennzeichnet, daß die Spannung so eingestellt wird, daß die zu beschichtende Oberfläche als Anode und die zweite Elektrode als Kathode polarisiert werden.

5. Verfahren nach einem der Ansprüche 1 und 2, dadurch gekennzeichnet, daß in der die monomeren Stickstoffverbindungen enthaltenden Lösung die zu beschichtende Metalloberfläche mit einer zweiten Metalloberfläche in elektrischen Kontakt gebracht wird, wobei die Art des Metalls der zweiten Metalloberfläche auf die Art des Metalls der zu beschichtenden Metalloberfläche so abgestimmt ist, daß das Metall der zu beschichtenden Oberfläche unedler ist als das Metall der zweiten Metalloberfläche.

6. Verfahren nach einem der Ansprüche 1 bis 5 zum Einsatz in der Leiterplattentechnik.

7. Verfahren nach einem der Ansprüche 1 bis 6 zur Erzeugung von Schichten, die als Ätzresist verwendet werden.

8. Verfahren nach einem der Ansprüche 1 bis 7, dadurch gekennzeichnet, daß die Beschichtung durch eine Behandlung in saurer wäßriger Lösung von der Metalloberfläche vollständig entfernt wird.

9. Verfahren nach einem der Ansprüche 1 bis 8, gekennzeichnet durch folgende Prozeßschritte:
(a) Erzeugen eines Negativbildes auf einer Leiterplatte mit einem alkalisch entfernbaren Resist auf mindestens einer Seite der Leiterplatte;
(b) Eintauchen der Leiterplatte in eine die monomeren Stickstoffverbindungen enthaltende saure Lösung, wobei zumindest zeitweise eine elektrische Spannung zwischen den Metalloberflächen der Leiterplatte und einer zweiten in die die monomeren Stickstoffverbindungen enthaltende Lösung eingetauchten Elektrode, die als Kathode gegenüber der Leiterplatte polarisiert wird, angelegt wird, oder sich aufgrund der Art der Metalle von selbst einstellt;
(c) gegebenenfalls Abspülen der überschüssigen Lösung;
(d) gegebenenfalls Trocknen beziehungsweise Tempern der Leiterplatte;
(e) selektives Entfernen des alkalisch entfernbaren Resists von der Leiterplattenoberfläche durch Eintauchen in eine alkalische Lösung, so daß die darunterliegenden Kupferflächen freigelegt werden;
(f) Entfernen der freigelegten Kupferflächen durch einen alkalischen Ätzprozeß.

10. Verfahren nach einem der Ansprüche 1 bis 9, dadurch gekennzeichnet, daß als monomere Stickstoffverbindungen solche ausgewählt werden, die in saurer wäßriger Lösung löslich und in alkalischer wäßriger Lösung unlöslich sind.

11. Verfahren nach einem der Ansprüche 1 bis 10, dadurch gekennzeichnet, daß cyclische Verbindungen, die mit einer nichtverzweigten, linearen oder verzweigten Alkylkette mit mindestens drei Kohlenstoffatomen und/oder mit einem aromatischen Rest, direkt oder über Alkylketten und/oder mit Aminogruppen direkt oder über Alkylketten, substituiert sind, als monomere Stickstoffverbindungen verwendet werden.

12. Verfahren nach einem der Ansprüche 1 bis 11, dadurch gekennzeichnet, daß die monomeren Stickstoffverbindungen in einer Konzentration von 0,001 g/l Lösung bis 400 g/l Lösung eingesetzt werden.

13. Verfahren nach einem der Ansprüche 1 bis 12, dadurch gekennzeichnet, daß der die monomeren Stickstoffverbindungen enthaltenden Lösung außerdem lösungsvermittelnde Alkohole, organische und/oder anorganische Säuren, Zusätze zur pH-Stabilisierung beziehungsweise aliphatische Amine zugegeben werden.

## Claims

1. Method of coating metals, wherein the surface to be coated is brought into contact with a solution containing a monomeric nitrogen compound, selected from the group of compounds imidazole, benzimidazole, triazole, benzotriazole, pyrazole, oxazole, isoxazole, thiazole, benzothiazole, indole, adenine, purine, chinoline, pyrazine, chinazoline, guanine, xanthine, hypoxanthine, indazole, creatinine, phenazine and derivatives thereof, as well as cupferron and benzamidine, or mixtures of these compounds, and a surface compound is formed on the metal by electrochemical reaction.

2. Method according to claim 1, characterised in that the metal ions required for forming the surface layer are produced wholly or partially by anodic dissolution.

3. Method according to one of claims 1 and 2, characterised in that an electric voltage between the surface to be coated and a second electrode, which is to be immersed in a bath with the solution containing the monomeric nitrogen compounds, is applied or set at least temporarily, so that an electric current flows between the surface to be coated and the second electrode.

4. Method according to one of claims 1 to 3, characterised in that the voltage is set in such a manner that the surface to be coated is polarised as the anode, and the second electrode is polarised as the cathode.

5. Method according to one of claims 1 and 2, characterised in that the metal surface to be coated is brought into electrical contact with the second metal surface in the solution containing the monomeric nitrogen compounds, the type of metal for the second metal surface being adapted to the type of metal for the metal surface to be coated in such a manner that the metal for the surface to be coated is less noble than the metal for the second metal surface.

6. Method according to one of claims 1 to 5 for use in printed circuit board technology.

7. Method according to one of claims 1 to 6 for producing layers which are employed as etching resist.

8. Method according to one of claims 1 to 7, characterised in that the coating is completely removed from the metal surface by a treatment in acidic aqueous solution.

9. Method according to one of claims 1 to 8, characterised by the following process steps:
(a) producing a negative image on a printed circuit board with an akalinely removable resist on at least one side of the printed circuit board;
(b) immersing the printed circuit board in an acidic solution containing the monomeric nitrogen compounds, an electric voltage being applied at least temporarily between the metal surfaces of the printed circuit board and a second electrode, which is immersed in the solution containing the monomeric nitrogen compounds and polarised as the cathode relative to the printed circuit board, or said electrode being automatically set because of the type of the metals;
(c) if necessary, rinsing-off the excess solution;
(d) if necessary, drying or tempering the printed circuit board;
(e) selectively removing the akalinely removable resist from the printed circuit board surface by immersion in an alkaline solution, so that the copper faces situated therebelow are exposed; and
(f) removing the exposed copper faces by an alkaline etching process.

10. Method according to one of claims 1 to 9, characterised in that the monomeric nitrogen compounds selected are those which are soluble in acidic aqueous solution and insoluble in alkaline aqueous solution.

11. Method according to one of claims 1 to 10, characterised in that cyclic compounds, which are substituted with an unbranched, linear or branched alkyl chain having at least three carbon atoms and/or having an aromatic residue are employed as monomeric nitrogen compounds directly or via alkyl chains and/or with amino groups directly or via alkyl chains.

12. Method according to one of claims 1 to 11, characterised in that the monomeric nitrogen compounds are used in a concentration of between 0.001 g/l solution and 400 g/l solution.

13. Method according to one of claims 1 to 12, characterised in that solubilising alcohols, organic and/or inorganic acids, additions for pH stabilising purposes, or respectively aliphatic amines, are also added to the solution containing the monomeric nitrogen compounds.

## Revendications

1. Procédé de revêtement de métaux, dans lequel la surface à revêtir est mise en contact avec une solution contenant un composé azoté monomère choisi dans le groupe des composés imidazole, benzimidazole, triazole, benzotriazole, pyrazole, oxazole, isoxazole, thiazole, benzothiazole, indole, adénine, purine, quinoline, pyrazine, quinazoline, guanine, xanthine, hypoxanthine, indazole, créatinine, phénazine et leurs dérivés ainsi que le cupferron et la benzamidine ou bien des mélanges de ces composés, et un composé de surface est formé sur le métal par réaction électrochimique.

2. Procédé selon la revendication 1, caractérisé en ce que les ions métalliques nécessaires pour former la couche de surface sont produits en tout ou partie par décomposition anodique.

3. Procédé selon l'une des revendications 1 et 2, caractérisé en ce qu'une tension est appliquée ou bien s'établit au moins de manière intermittente entre la surface à revêtir et une deuxième électrode plongée dans un bain de la solution contenant les composés azotés monomères, de telle sorte qu'un courant électrique circule entre la surface à revêtir et la deuxième électrode.

4. Procédé selon l'une des revendications 1 à 3, caractérisé en ce que la tension s'établit de telle sorte que la surface à revêtir est polarisée comme anode et la deuxième électrode comme cathode.

5. Procédé selon l'une des revendications 1 et 2, caractérisé en ce que la surface métallique à revêtir est mise en contact électrique dans la solution contenant les composés azotés monomères avec une deuxième surface métallique, la nature du métal de la deuxième surface métallique étant déterminée de telle sorte que le métal de la surface à revêtir est moins noble que le métal de la deuxième surface métallique.

6. Procédé selon l'une des revendications 1 à 5, pour une utilisation dans la technique des circuits imprimés.

7. Procédé selon l'une des revendications 1 à 6, pour produire des couches qui sont utilisées comme épargne de gravure.

8. Procédé selon l'une des revendications 1 à 7, caractérisé en ce que le revêtement est complètement éliminé de la surface métallique par traitement dans une solution aqueuse acide.

9. Procédé selon l'une des revendications 1 à 8, caractérisé en ce qu'il comprend les étapes consistant à:
a) réaliser une image négative sur un circuit imprimé avec un vernis épargne pouvant être enlevé par voie alcaline sur au moins une face du circuit imprimé ;
b) plonger le circuit imprimé dans une solution acide contenant les composés azotés monomères, une tension électrique étant appliquée ou s'établissant d'elle-même en fonction de la nature des métaux, au moins de manière intermittente, entre les surfaces métalliques du circuit imprimé et une deuxième électrode plongée dans la solution contenant les composés azotés monomères et polarisée en tant que cathode par rapport au circuit imprimé ;
c) le cas échéant éliminer l'excès de solution par rinçage ;
d) le cas échéant sécher ou étuver le circuit imprimé ;
e) éliminer sélectivement le vernis épargne pouvant être enlevé par voie alcaline de la surface du circuit imprimé en le plongeant dans une solution alcaline de manière à exposer les surfaces de cuivre sous-jacentes.
f) éliminer les surfaces de cuivre exposées par un procédé de gravure alcalin.

10. Procédé selon l'une des revendications 1 à 9, caractérisé en ce que l'on choisit comme composés azotés monomères ceux qui sont solubles dans une solution aqueuse acide et insolubles dans une solution aqueuse alcaline.

11. Procédé selon l'une des revendications 1 à 10, caractérisé en ce que l'on utilise comme composés azotés monomères des composés cycliques substitués par une chaîne alkyle non ramifiée, linéaire ou ramifiée possédant au moins trois atomes de carbone et/ou par un radical aromatique, directement ou par l'intermédiaire de chaînes alkyles, et/ou par des groupes amino, directement ou par l'intermédiaire de chaînes alkyles.

12. Procédé selon l'une des revendications 1 à 11, caractérisé en ce que les composés azotés monomères sont utilisés à une concentration de 0,001 g/l de solution à 400 g/l de solution.

13. Procédé selon l'une des revendications 1 à 12, caractérisé en ce que l'on ajoute en plus à la solution contenant les composés azotés monomères des alcools favorisant la solubilité, des acides organiques et/ou inorganiques, des additifs de stabilisation du pH ou des amines aliphatiques.
